# EUROPEAN PATENT APPLICATION

(11) **EP 2 525 633 A1**
(43) Date of publication of application: **21.11.2012**
(21) Application number: 11732842.7
(22) Date of filing: 07.01.2011
(51) Int. Cl.: H05K 1/09, B32B 15/08, C23C 18/52, C23C 28/02, C25D 5/10, C25D 7/00, H05K 3/06

(54) **ELECTRONIC CIRCUIT, METHOD FOR FORMING SAME, AND COPPER CLAD LAMINATE FOR ELECTRONIC CIRCUIT FORMATION**

(30) Priority: 15.01.2010 JP 2010006496
(71) Applicant: JX Nippon Mining & Metals Corporation, Tokyo 100-8164 (JP)
(72) Inventor: YAMANISHI Keisuke, Hitachi-city Ibaraki 317-0056 (JP); FUKUCHI Ryo, Hitachi-city Ibaraki 317-0056 (JP); KAMINAGA Kengo, Hitachi-city Ibaraki 317-0056 (JP)
(74) Representative: Hoarton, Lloyd Douglas Charles
(86) International application number: PCT/JP2011/050143
(87) International publication number: WO 2011/086972

(57) **Abstract**

Provided is an electronic circuit as a laminated body configured from a layer (A) which is made of a copper or copper alloy foil formed on one surface or both surfaces of a resin substrate, a copper or copper alloy plated layer (B) formed on a part or whole surface of the (A) layer, a plated layer (C) formed on a part or whole surface of the (B) layer and having a slower etching rate than that of copper relative to a copper etching solution, and a copper or copper alloy plated layer (D) formed on the layer (C) and which has a thickness of 0.05 µm or more and less than 1 µm, and which is made of a copper circuit formed by etching and removing a part of the laminated portion of the (A) layer, the (B) layer, the (C) layer and the (D) layer up to the resin substrate surface. It is thereby possible to form a circuit having a uniform circuit width, improve the etching properties in pattern etching, and prevent the occurrence of short-circuits and defects in the circuit width.

## Description

### TECHNICAL FIELD

The present invention relates to an electronic circuit which is formed via etching, a method of forming such an electronic circuit, and a copper clad laminate for forming an electronic circuit.

### BACKGROUND ART

A copper foil for a printed circuit is broadly used in electronic and electrical equipment, and this copper foil for a printed circuit is generally bonded to a base material such as a synthetic resin board or a film via an adhesive, or bonded under high temperature and high pressure without using an adhesive to prepare a copper clad laminate, a circuit is thereafter printed via resist application and exposure processing for forming the intended circuit, etching treatment is subsequently performed to remove the unwanted portions of the copper foil, and the various elements are soldered to form a printed circuit for electronic devices.

A copper foil for use in this kind of printed circuit can be broadly classified into an electrolytic copper foil and a rolled copper foil based on the difference in the type of production method thereof, but both of these copper foils are used according to the type of printed circuit board or the demanded quality.

These copper foils have a face which is bonded with a resin base material, and a face which is not bonded, and these faces are respectively subject to special surface processing (treatment). There are cases where both surfaces of the copper foil are processed to have a bonding function with resin (double treatment). The copper foil which is used as an inner layer of a multilayer printed circuit board, for example, has its both surfaces being processed.

An electrolytic copper foil is generally manufactured by electrodepositing copper on a rotating drum, and sequentially peeling the electrodeposited copper to form a copper foil. The face which comes into contact with the rotating drum during the foregoing production has a glossy surface, and the opposite face (rough surface) has numerous irregularities. Nevertheless, copper particles of roughly 0.2 to 3 µm are generally affixed even to the foregoing rough surface in order to further improve the adhesiveness with the resin substrate.

In addition, there are cases where a thin plated layer is formed to prevent the dropping of copper particles after enhancing the foregoing irregularities. These series of processes are referred to as roughening treatment. This kind of roughening treatment is also demanded in a rolled copper foil in addition to an electrolytic copper foil, and similar roughening treatment is also being performed to a rolled copper foil.

A copper clad laminate is produced by subjecting the foregoing copper foil to the hot press method or the continuous method. Taking the foregoing hot press method as an example, this laminate is produced, for instance, by synthesizing epoxy resin, impregnating phenol resin in a paper base material and drying the same to prepare a prepreg, and subjecting the prepreg and the copper foil to thermocompression molding using a combination pressing machine. Otherwise, there is also a method of drying and solidifying a polyimide precursor solution on a copper foil, and thereby forming a polyimide resin layer on the copper foil.

There is also a method of performing surface treatment such as plasma treatment to the resin film made of polyimide, and thereafter directly forming, as needed, a copper layer having the same thickness as the copper foil via an adhesive layer made of Ni-Cr or the like. The present invention collectively refers to a product in which a copper layer is formed on a resin layer as a "copper clad laminate" in the ensuing explanation.

The copper clad laminate produced as described above is subject to the processes of printing a circuit via resist application and exposure processing for forming the intended circuit, and etching treatment for removing the unwanted parts of the copper layer. However, upon etching and forming a circuit, there is a problem in that the circuit does not become the width as per the mask pattern that is formed on the surface in advance.

This is caused by the copper circuit formed by etching being etched downward from the surface of the copper layer; that is, etched in a manner of spreading out wide toward the resin layer (occurrence of " decrease in width of circuits" which hereinafter is referred to as "sagging"). When considerable "sagging" occurs, the copper circuit will short-circuit near the resin substrate, and become defective in certain cases.

It is necessary to reduce the occurrence of length of tail of circuits, as much as possible. In order to prevent the short-circuit of the copper circuit near the resin substrate, extending the etching time to perform more etching and reduce the "sagging" was considered, for example.

Nevertheless, if there is a location that has already reached a predetermined width dimension in the foregoing case, there is a problem in that such location will be further etched and cause the circuit width to be narrower by that much, and the uniform line width (circuit width) that is intended in the circuit design cannot be obtained. Here, there is a particular problem in that such location (thinned portion) will generate heat and, in certain cases, break.

While the finer patterns of an electronic circuit are being achieved, the foregoing problem of defects caused by etching is still frequently encountered even today, and this is a major problem in terms of circuit formation.

In order to overcome the foregoing problems, the present inventors proposed a copper foil in which a metal or alloy layer (hereinafter referred to as the "EF layer") having a slower etching rate than that of copper is formed on the copper foil on the etching face side (refer to Patent Document 1). As the metal or alloy in the foregoing case, nickel, cobalt and the alloys thereof are used, and, by forming the metal or alloy layer to have a thickness that is sufficiently thinner than the copper circuit thickness, it is possible to perform etching with minimal sagging and without excessively thinning the formed circuit.

In other words, upon designing a circuit, since the etching solution will infiltrate from the resist application side to become the mask pattern; that is, from the surface of the copper foil, by forming the EF layer immediately below the resist within a range of a predetermined amount of adhesion, etching of the copper foil portion near that region is inhibited and etching of the other copper foil portions will advance. Thus, effects are yielded in that "sagging" is reduced and a circuit having a more uniform width can be formed, which was considerable advancement compared to conventional technologies.

Upon attempting to achieve further improvement, several problems arose: one of them is that upon additionally forming a "surface coated layer" such as tin plating or nickel plating on the foregoing EF layer as a pre-process of circuit formation, the adhesiveness of the EF layer and the plated layer formed on the EF layer is low.

Thus, it was necessary to remove the EF layer via soft etching or the like after forming the circuit. In other words, there is a problem in that the improvement effect of the circuit shape is reduced due to soft etching or the like.
[Patent Document 1] Japanese Unexamined Patent Application Publication No. 2002-176242

### SUMMARY OF THE INVENTION

### [Problems to be Solved by the Invention]

An object of this invention is to obtain an electronic circuit capable of preventing sagging caused by etching upon forming a circuit by etching a copper layer of a copper clad laminate, enabling the formation of a uniform circuit having the intended circuit width, improving the etching properties in pattern etching, and preventing the occurrence of short circuits and defects in the circuit width, a method of forming such an electronic circuit, and a copper clad laminate for forming an electronic circuit. The present invention, particularly aims to prevent the adhesiveness of the surface coated layer from being impaired by the copper or copper alloy layer formed on the EF layer and enable the formation of a uniform circuit width, upon forming a plated layer at the upper part of the circuit.

### [Means for Solving the Problems]

The present inventors discovered that the foregoing problems can be resolved by additionally providing a copper or copper alloy layer, which has an appropriate thickness, on the foregoing EF layer after such EF layer is formed. This is explained below. Note that the term "plating" as used in the ensuing explanation of the present invention includes wet plating methods such as electroplating and electroless plating, chemical plating methods, or physical plating methods such as vapor deposition and sputtering, and these means may be arbitrarily selected and used so as long as there is no particular hindrance.

Based on the foregoing discovery, the present invention provides:
1) An electronic circuit as a laminated body configured from a layer (A) which is made of a copper or copper alloy foil formed on one surface or both surfaces of a resin substrate, a copper or copper alloy plated layer (B) formed on a part or whole surface of the (A) layer, a plated layer (C) formed on a part or whole surface of the (B) layer and which has a slower etching rate than that of copper relative to a copper etching solution, and a copper or copper alloy plated layer (D) formed on the layer (C) and which has a thickness of 0.05 µm or more and less than 1 µm, and which is made of a copper circuit formed by etching and removing a part of the laminated portion of the (A) layer, the (B) layer, the (C) layer and the (D) layer up to the resin substrate surface.

Moreover, the present invention provides:
2) An electronic circuit as a laminated body configured from a copper or copper alloy layer (A) which is formed on one surface or both surfaces of a resin substrate, a plated layer (C) formed on a part or whole surface of the (A) layer and has a slower etching rate than that of copper relative to a copper etching solution, and a copper or copper alloy plated layer (D) formed on the layer (C) and which has a thickness of 0.05 µm or more and less than 1 µm, and which is made of a copper circuit formed by etching and removing a part of the laminated portion of the (A) layer, the (C) layer and the (D) layer up to the resin substrate surface.

The present invention additionally provides:
3) The electronic circuit according to 1) or 2) above, wherein the layer (C) which has a slower etching rate than that of copper relative to a copper etching solution is made of nickel, cobalt or nickel alloy; and
4) The electronic circuit according to any one of 1) to 3) above, wherein an amount of adhesion of the layer (C) is 100 µg/dm² to 3000 µg/dm².

The present invention additionally provides:
5) The electronic circuit according to any one of 1) to 4) above, wherein a face which is opposite to a face of the copper or copper alloy layer (A) in contact with the resin is a face that is subject to one or more treatments among acid cleaning treatment, soft etching, and surface roughening treatment.

The present invention additionally provides:
6) The electronic circuit according to any one of 1) to 5) above, wherein a face which is opposite to a face of the copper or copper alloy layer (A) in contact with the resin is a face that is subject to thickness reduction via one or more treatments among acid cleaning treatment, soft etching, and surface roughening treatment.

The present invention additionally provides:
7) The electronic circuit according to any one of 1) to 6) above, wherein the copper or copper alloy layer (D) is a copper or copper alloy layer having a thickness of 0.05 µm or more and 0.8 µm or less.

The present invention additionally provides:
8) The electronic circuit according to any one of 1) to 6) above, wherein the copper or copper alloy layer (D) is a copper or copper alloy layer having a thickness of 0.1 µm or more and 0.5 µm or less.

The present invention additionally provides:
9) The electronic circuit according to any one of 1) to 8) above, wherein a heat-resistant layer and/or a chromate or organic anticorrosion layer is additionally provided on the copper or copper alloy layer (D).

The present invention additionally provides:
10) The electronic circuit according to any one of 1) to 9) above, wherein a tin, nickel or gold plated layer, or a tin alloy, nickel alloy or gold alloy plated layer, or a solder plated layer is additionally provided on the copper or copper alloy layer (D) or on the heat-resistant layer and/or the chromate or organic anticorrosion layer.

The present invention additionally provides:
11) A method of forming an electronic circuit, including a step of preparing a copper clad laminate by forming a copper or copper alloy layer (A) on one surface or both surfaces of a resin substrate, forming a copper or copper alloy plated layer (B) on a part or whole surface of the (A) layer, forming a plated layer (C), which has a slower etching rate than that of copper relative to a copper etching solution, on a part or whole surface of the (B) layer, and forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (B) layer, the (C) layer and the (D) layer of the copper clad laminate up to the resin substrate surface.

The present invention additionally provides:
12) A method of forming an electronic circuit, including a step of preparing a copper clad laminate by forming a copper or copper alloy layer (A) on one surface or both surfaces of a resin substrate, forming a through-hole on the copper clad laminate, additionally forming a copper or copper alloy plated layer (B) on a part or whole surface of the (A) layer and in the through-hole, subsequently forming a plated layer (C), which has a slower etching rate than that of copper relative to a copper etching solution, on a part or whole surface of the (B) layer, and additionally forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (B) layer, the (C) layer and the (D) layer of the copper clad laminate up to the resin substrate surface.

The present invention additionally provides:
13) A method of forming an electronic circuit, including a step of preparing a copper clad laminate by forming a copper or copper alloy layer (A) on one surface or both surfaces of a resin substrate, subsequently forming a plated layer (C), which has a slower etching rate than that of copper relative to a copper etching solution, on a part or whole surface of the (A) layer, and additionally forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (C) layer and the (D) layer of the copper clad laminate up to the resin substrate surface.

The present invention additionally provides:
14) The method of forming an electronic circuit according to any one of 11) to 13) above, wherein, as the copper foil to be used upon forming the copper or copper alloy layer (A) on one surface or both surfaces of the resin substrate, used is a copper foil in which a plated layer (C') having a slower etching rate than that of copper relative to a copper etching solution is provided to the copper foil surface in advance.

The present invention additionally provides:
15) The method of forming an electronic circuit according to any one of 11) to 14) above, wherein a heat-resistant layer and/or an anticorrosion layer is formed on the (C) or (C') layer.

The present invention additionally provides:
16) The method of forming an electronic circuit according to any one of 11) to 15) above, wherein the layer (C) or layer (C') which has a slower etching rate than that of copper relative to a copper etching solution is made of nickel, cobalt or nickel alloy.

The present invention additionally provides:
17) The method of forming an electronic circuit according to any one of 11) to 16) above, wherein an amount of adhesion of the layer (C) or layer (C') is adjusted to be 100 µg/dm² to 3000 µg/dm².

The present invention additionally provides:
18) The method of forming an electronic circuit according to any one of 11) to 17) above, wherein the copper or copper alloy layer (A) is subject to one or more treatments among acid cleaning treatment, soft etching, and surface roughening treatment.

The present invention additionally provides:
19) The method of forming an electronic circuit according to any one of 11) to 17) above, wherein the copper or copper alloy layer (A) is subject to thickness reduction via one or more treatments among acid cleaning treatment, soft etching, and surface roughening treatment.

The present invention additionally provides:
20) The method of forming an electronic circuit according to any one of 15) to 17) above, further including a step of removing the heat-resistant layer and/or the anticorrosion layer via acid cleaning treatment or soft etching.

The present invention additionally provides:
21) The method of forming an electronic circuit according to any one of 11) to 20) above, wherein the copper or copper alloy layer (D) is formed to have a thickness of 0.05 µm or more and 0.8 µm or less.

The present invention additionally provides:
22) The method of forming an electronic circuit according to any one of 11) to 20) above, wherein the copper or copper alloy layer (D) is formed to have a thickness of 0.1 µm or more and 0.5 µm or less.

The present invention additionally provides:
23) The method of forming an electronic circuit according to any one of 11) to 22) above, wherein a tin, nickel or gold plated layer, or a tin alloy, nickel alloy or gold alloy plated layer, or a solder plated layer is additionally formed on the copper or copper alloy layer (D) or on the heat-resistant layer and/or the chromate or organic anticorrosion layer.

The present invention additionally provides:
24) A copper clad laminate for forming an electronic circuit configured from a copper or copper alloy layer (A) formed on one surface or both surfaces of a resin substrate, a copper or copper alloy plated layer (B) formed on a part or whole surface of the (A) layer, a plated layer (C) formed on a part or whole surface of the (B) layer and having a slower etching rate than that of copper relative to a copper etching solution, and a copper or copper alloy plated layer (D) formed on the layer (C) and which has a thickness of 0.05 µm or more and less than 1 µm.

The present invention additionally provides:
25) A copper clad laminate for forming an electronic circuit configured from a copper or copper alloy layer (A) formed on one surface or both surfaces of a resin substrate, a plated layer (C) formed on a part or whole surface of the (A) layer and having a slower etching rate than that of copper relative to a copper etching solution, and a copper or copper alloy plated layer (D) formed on the layer (C) and which has a thickness of 0.05 µm or more and less than 1 µm.

The present invention additionally provides:
26) The copper clad laminate for forming an electronic circuit according to 24) or 25) above, wherein the layer (C) having a slower etching rate than that of copper relative to a copper etching solution is made of nickel, cobalt or nickel alloy.

The present invention additionally provides:
27) The copper clad laminate for forming an electronic circuit according to any one of 23) to 25) above, wherein an amount of adhesion of the layer (C) is 100 µg/dm² to 3000 µg/dm².

The present invention additionally provides:
28) The copper clad laminate for forming an electronic circuit according to any one of 24) to 27) above, wherein a face which is opposite to a face of the copper or copper alloy layer (A) in contact with the resin is a face that is subject to one or more treatments among acid cleaning treatment, soft etching, and surface roughening treatment.

The present invention additionally provides:
29) The copper clad laminate for forming an electronic circuit according to any one of 24) to 28) above, wherein a face which is opposite to a face of the copper or copper alloy layer (A) in contact with the resin is a face that is subject to thickness reduction via one or more treatments among acid cleaning treatment, soft etching, and surface roughening treatment.

The present invention additionally provides:
30) The copper clad laminate for forming an electronic circuit according to any one of 24) to 29) above, wherein the copper or copper alloy layer (D) is a copper or copper alloy layer having a thickness of 0.05 µm or more and 0.8 µm or less.

The present invention additionally provides:
31) The copper clad laminate for forming an electronic circuit according to any one of 24) to 29) above, wherein the copper or copper alloy layer (D) is a copper or copper alloy layer having a thickness of 0.1 µm or more and 0.5 µm or less.

The present invention additionally provides:
32) The copper clad laminate for forming an electronic circuit according to any one of 24) to 31) above, wherein a heat-resistant layer and/or a chromate or organic anticorrosion layer is additionally provided on the copper or copper alloy layer (D).

The present invention additionally provides:
33) The copper clad laminate for forming an electronic circuit according to any one of 24) to 32) above, wherein a tin, nickel or gold plated layer, or a tin alloy, nickel alloy or gold alloy plated layer, or a solder plated layer is additionally provided on the copper or copper alloy layer (D) or on the heat-resistant layer and/or the chromate or organic anticorrosion layer.

The present invention additionally provides:
34) The copper clad laminate for forming an electronic circuit according to any one of 24) to 33) above, wherein a copper clad laminate is prepared by forming a copper or copper alloy layer (A) on one surface or both surfaces of a resin substrate, forming a through-hole on the copper clad laminate, and additionally forming a copper or copper alloy plated layer (B) on a part or whole surface of the (A) layer and in the through-hole.

The present invention additionally provides:
35) The copper clad laminate for forming an electronic circuit according to 34) above, wherein at least either the copper or copper alloy layer (A) formed on one surface or both surfaces of the resin substrate prior to the formation of a through-hole or a plated layer (through-hole plated layer) made of the subsequently formed copper or copper alloy layer (B) is subject to thickness reduction treatment via acid cleaning or/and soft etching.

While the etching of a copper circuit as the electronic circuit on a copper clad laminate was explained above, if a more vertical shape is intended via the etching process, the present invention can also be applied to various related technologies such as the formation of copper bumps as one mode of the electronic circuit.

### [Effect of the Invention]

The present invention yields the effect of being able to form a uniform circuit having the intended circuit width upon forming a circuit by etching a copper layer of a copper clad laminate, and additionally yields the effect of being able to prevent the occurrence of sagging caused by etching.

The present invention, particularly can prevent the adhesiveness of the "surface coated layer" from being impaired by the copper or copper alloy layer formed on the EF layer and enable the formation of a uniform circuit width, upon forming a plated layer at the upper part of the circuit,.

Consequently, the present invention yields superior effects of being able to provide a method of forming a superior electronic circuit capable of improving the etching properties in pattern etching, and preventing the occurrence of short circuits and defects in the circuit width.

### BRIEF DESCRIPTION OF THE INVENTION

Fig. 1 is a diagram of the cross section of the etching of the circuit shown in Example 4.
Fig. 2 is a diagram showing the cross section of the etching of the circuit shown in Comparative Example 3.

### DETAILED DESCRIPTION OF THE INVENTION

The present invention relates to an electronic circuit which is formed via etching, a method of forming such an electronic circuit, and a copper clad laminate for forming an electronic circuit.

As one mode for achieving the object of the present invention, foremost, a copper or copper alloy layer (B) is formed on a copper or copper alloy layer (A) formed on a resin substrate. In other words, the copper layer (B) is a copper layer that is newly formed on the copper clad laminate via through-hole plating or the like. As another mode, the (A) layer is subject to thickness reduction via soft etching and so on.

Here, the copper or copper alloy layer (A) may be a plated layer that is directly formed on the resin substrate or a copper or copper alloy layer made bonded foils. In other words, with respect to the foregoing (A) layer, rather than using a copper foil, it is also possible to use a copper clad laminate, in which a copper layer is directly formed thereon, after performing surface treatment such as plasma treatment to the resin film made of polyimide. In the foregoing case, as with the case were the foil to be bonded is a foil that does not comprise an EF layer in advance, the surface does not comprise an EF layer at this stage.

Subsequently, a (C) layer which has a slower etching rate than that of copper relative to a copper etching solution is formed on the (B) layer, or on the (A) layer which was subject to thickness reduction via soft etching, or on the (A) layer using a copper foil in which an EF layer is not formed thereon in advance.

As this (C) layer, a material having a slower etching rate than that of copper relative to a copper etching solution is selected. As this material, nickel, cobalt, or nickel alloy can be used.

Particularly, nickel or nickel alloy is desirable.

To explain this in detail by taking a nickel or nickel alloy layer as an example, the etching rate of the copper foil on the resist side located close to the resist portion on the copper foil will be inhibited by the nickel or nickel alloy layer. Contrarily, as the copper foil is located farther from the nickel or nickel alloy layer, the etching of copper will proceed at a normal rate.

Consequently, etching advances substantially vertically from the resist side of the side face of the copper circuit toward the resin substrate side, and a rectangular copper foil circuit is thereby formed.

A nickel or nickel alloy layer or the like mainly inhibits the occurrence of sagging, and enables the formation of a uniform circuit of the intended circuit width.

Upon forming a fine circuit, an etching solution made of aqueous ferric chloride having a fast etching rate is preferably used. This is because there is a problem in that the etching rate will deteriorate as the circuit becomes finer. An etching solution made of aqueous ferric chloride is an effective means for preventing the foregoing problem. Nevertheless, other etching solutions may also be used. The etching solution may be changed as needed.

Upon forming an electronic circuit, a tin, nickel or gold plated layer, or a tin alloy, nickel alloy or gold alloy plated layer, or a solder plated layer is often formed, but a "surface coated layer" does not easily attach to the nickel, cobalt, or nickel alloy that is used as the material of the (C) layer. Thus, preferably, a copper or copper alloy plated layer (D) is formed on the (C) layer of the laminated body in advance.

Upon forming a copper circuit by etching and removing, up to the resin substrate surface, a part of the laminated portion configured from the (A) layer, the (B) layer, the (C) layer and the (D) layer, there is a problem in that, if the (D) layer is too thick, this becomes an impediment in the etching process, and disables the formation of a uniform circuit width.

In other words, the function of the (C) layer as the EF layer that is formed for forming a uniform circuit width is inhibited. Nevertheless, as described above, to form a copper or copper alloy plated layer (D) on the (C) layer of the laminated body in advance may be required for additionally forming a "surface coated layer" thereon.

With respect to this point, testing was repeatedly performed, and the optimal condition was discovered. This condition is causing the thickness of the copper or copper alloy plated layer (D) formed on the (C) layer, which is the EF layer, to be 0.05 µm or more and less than 1 µm. When the plated layer (D) is a copper alloy, for instance, copper alloy such as brass plating (Zn 10 to 40%), bronze plating (Sn to 10%), or cupronickel plating (Ni 10 to 30%) can be used.

As a result of testing, the foregoing thickness is preferably 0.05 µm or more and 0.8 µm or less, and more preferably 0.1 µm or more and 0.5 µm or less.

The lower limit is 0.05 µm as described above, and this is the minimum required thickness for forming a "surface coated layer" thereon. Meanwhile, to increase the foregoing thickness will become an obstacle to the etching process, and disable the formation of a uniform circuit width. The reason for this will be explained in detail in the Examples.

It is also possible to additionally form a chromium layer or a chromate layer and/or a silane-treated organic anticorrosion layer on the (D) layer. In the foregoing case, while there is a possibility that a difference may arise in the etching rate relative to the pattern etching solution, as a result of appropriately selecting the amount thereof, it is possible to similarly inhibit the oxidation of the surface of the (D) layer. Thus, it is possible to form an even more stable circuit width pattern.

Moreover, the amount of nickel contained in the (C) layer is 100 µg/dm² to 3000 µg/dm², preferably 2250 µg/dm² or less, and more preferably 1500 µg/dm² or less. This amount is required for inhibiting the occurrence of sagging during the circuit etching and for etching a uniform circuit.

If the amount of nickel is less than 100 µg/dm², the effect thereof will deteriorate. Thus, the amount of nickel is preferably 200 µg/dm² or more, and more preferably 300 µg/dm² or more.

Meanwhile, if the amount of nickel is too large, the load (etching time) of the process will increase during the etching, and become an obstacle in designing a copper circuit. Thus, the amount of nickel needs to be within the foregoing range.

When providing the chromium layer or the chromate layer to the rolled copper foil or electrolytic copper foil for an electronic circuit of the present invention, the chromium content is set to be 100 µg/dm² or less based on metal/chromium conversion. And, when forming the silane treatment layer, the silane content is preferably 20 µg/dm² or less based on silicon conversion. This is in order to inhibit the occurrence of a difference in the etching rate relative to the pattern etching solution. Nevertheless, a moderate amount is effective to prevent the oxidation of the (C) layer and the (D) layer.

Examples of typical and preferred plating conditions are shown below.
(Copper plating)
Cu: 90 g/L
H₂SO₄: 80 g/L
Cl: 60ppm
Liquid Temperature: 55 to 57°C
Additive: bis (3-sulfopropyl) disulfide 2 sodium (CPS manufactured by RASCHIG), dibenzylamine denaturant
(Nickel plating)
Ni: 10 to 40 g/L
pH: 2.5 to 3.5
Temperature: Ordinary temperature to 60°C
Current Density Dk: 2 to 50 A/dm²
Time: 1 to 4 seconds
(Nickel-phosphorus alloy plating)
Ni: 50 to 100 g/L
P: 1 to 25 g/L
HBO₃: 0 to 30 g/L
pH: 0.5 to 2.5
Temperature: Ordinary temperature to 95°C
Current Density Dk: 5 to 40 A/dm²
Time: 1 to 10 seconds
(Nickel-molybdenum alloy plating)
Ni: 5 to 25 g/L
Mo: 0.01 to 5 g/L
Na₂P₂O₇: 160 g/L
pH: 8 to 9
Temperature: Ordinary temperature to 40°C
Current Density Dk: 1 to 5 A/dm²
Time: 1 to 10 seconds
(Nickel-tungsten alloy plating)
Ni: 1 to 10 g/L
W: 20 to 50 g/L
Citric acid: 60 g/L
pH: 8 to 9
Temperature: Ordinary temperature to 50°C
Current Density Dk: 0.1 to 5 A/dm²
Time: 1 to 10 seconds
(Cobalt plating)
Co: 10 to 40 g/L
pH: 2.5 to 3.5
Temperature: Ordinary temperature to 60°C
Current Density Dk: 2 to 50 A/dm²
Time: 1 to 4 seconds
(Chromate treatment conditions)
(A) Dipping chromate treatment
K₂Cr₂O₇(Na₂Cr₂O₇ or CrO₃): 0.1 to 5 g/liter
pH: 2 to 13
Temperature: Ordinary temperature to 60°C
Time: 5 to 30 seconds
(B) Electrolytic chromate treatment
K₂Cr₂O₇(Na₂Cr₂O₇ or CrO₃): 2 to 10 g/liter
NaOH or KOH: 10 to 50 g/liter
pH: 7 to 13
Bath Temperature: 20 to 80°C
Current Density Dk: 0.05 to 5 A/dm²
Time: 5 to 30 seconds
Anode: Pt-Ti plate, lead plate, etc.
(Silane treatment conditions)

Silane of various series shown below was selected. Silane dissolved in alcohol was diluted with water to a predetermined concentration, and then applied to the copper foil surface.

### Concentration: 0.01 wt% to 2 wt%

Type: olefin-based silane, epoxy-based silane, acrylic silane, amino-based silane, mercapto-based silane

### (Method of analyzing amount of adhesion of nickel, etc.)

In order to analyze the nickel-treated surface, the opposite face was prepared by pressing and masking FR-4 resin. This sample was dissolved in nitric acid in a concentration of 30% until the surface-treated film dissolved, the solution in a beaker was diluted tenfold, and the nickel was subject to quantitative analysis based on atomic absorption analysis.

### (Method of analyzing amount of adhesion of chromium)

In order to analyze the treated surface, the opposite face was prepared by pressing and masking FR-4 resin. This sample was boiled for three minutes in hydrochloric acid in a concentration of 10% to dissolve the treated layer, and the solution thereof was used to subject zinc and chromium to quantitative analysis based on atomic absorption analysis.

As described above, a resist pattern for forming a circuit was formed on the (D) layer, and an etching solution made of a copper chloride solution or a ferric chloride solution was used to remove, up to the resin substrate surface, the unwanted portions of the laminated portions the (A) layer, the (B) layer, the (C) layer and the (D) layer on the resin substrate other than the portion provided with the resist pattern. Subsequently, the resist was removed.

The foregoing can be realized by combining the (A) layer, the (B) layer, the (C) layer, and the (D) layer described above, and this is one of the superior features of the present invention.

To present further favorable conditions, after attaching the (A) layer of copper or copper alloy to a plated layer or copper foil as described above, desirably, the layer provided on the exposed face of the (A) layer, which is the copper foil, for protecting the copper foil is removed via etching in advance prior forming the (B) layer. This is in order to facilitate the adhesion of the subsequent plated layers.

When a copper foil is used as the copper or copper alloy layer to be formed on the resin substrate, while the process can be applied to either the roughened surface (M surface) or the glossy surface (S surface) of the electrolytic copper foil, the surface to be etched is normally the glossy surface side. When a rolled copper foil is used, a high purity rolled copper foil or a reinforced rolled alloy copper foil can also be used. The present invention covers all of these copper foils.

### [Examples]

Examples and Comparative Examples of the present invention are now explained. Note that the Examples are described for facilitating the understanding of the invention, and the present invention is not limited to the following Examples. Namely, the present invention covers all modes or modifications other than the Examples described below within the scope of the technical features described in this specification.

While the following Examples used the solution/conditions ([0062]) described in Japanese Unexamined Patent Application Publication No. 2004-107786 filed by the present Applicant as the copper plating solution/conditions, other copper plating solution/conditions may also be used.

### (Example 1)

An electrolytic copper foil had a foil thickness of 18 µm. The electrolytic copper foil was bonded to a polyimide resin substrate to form a copper clad laminate. Subsequently, a copper plated layer of 20 µm was formed on the copper clad laminate. The copper plating was performed under the foregoing conditions. Consequently, the total thickness of the electrolytic copper foil and the copper plated layer on the resin substrate was 38 µm.

Subsequently, a nickel-tungsten plated layer in an amount of 400 µg/dm² was formed on the copper plated layer in the foregoing nickel-tungsten plating conditions, a copper plated layer (D) having a thickness of 0.1 µm was formed thereon in the foregoing copper plating conditions, and a chromate layer was additionally formed therein in the foregoing chromate conditions.

Ten circuits of a 400 µm pitch were printed, based on resist application and exposure processing, on the copper clad laminate with the nickel-tungsten plated layer formed thereon, unwanted portions of the copper foil were removed, and a surface coated layer was thereafter formed.
(Electroless tin plating conditions)
Rohm and Haas: LT-34
Liquid Temperature: 75°C
Dipping Time: 5 minutes
(Electroless nickel plating conditions)
Ebara-Udylite AC-DX
Liquid Temperature: 90°C
Dipping Time: 20 minutes

An electroless tin plated layer was additionally formed on the (D) layer, and it was possible to form a favorable electroless tin plated layer with high adhesiveness.

### (Example 2)

In Example 2, a rolled copper foil had a thickness of 12 µm, the rolled copper foil was bonded to a polyimide resin substrate to form a copper clad laminate. And, the copper clad laminate was subject to soft etching, and a part of the copper layer was thereby removed. Consequently, thickness of the copper was 5 µm.

### (Soft etching conditions)

Sulfuric acid-hydrogen peroxide mixed solution (sulfuric acid 165 g/L, hydrogen peroxide solution 21 g/L) was used, and the thickness reduction of the copper layer was performed at 35°C via dipping and agitation.

A nickel-molybdenum plated layer in an amount of 600 µg/dm² was formed on the copper clad laminate in the foregoing nickel-molybdenum plating conditions. A copper plated layer of 0.2 µm was additionally formed thereon in the foregoing copper plating conditions.

Ten circuits were printed thereon based on resist application and exposure processing, and etching treatment for removing the unwanted portions of the copper foil was performed.

An electroless nickel plated layer was additionally formed on the (D) layer, and it was possible to form a favorable electroless nickel plated layer with high adhesiveness.

### (Example 3)

In this Example, a copper clad laminate was prepared by bonding a rolled copper alloy (Cu-0.2 wt% Cr-0.1 wt% Zr) foil of 12 µm, in which a Ni-plated layer in a Ni plating amount of 700 µg/dm² was formed thereon in advance, to a resin substrate (polyimide-based resin). After forming a through-hole on the copper clad laminate, electroless plating and electroplating were performed to plate copper in a total thickness of 26 µm. The total thickness of the copper alloy and the copper plated layer was 38 µm.

A nickel-phosphorus plated layer in an amount of 700 µg/dm² was formed on the copper clad laminate with the foregoing copper plated layer formed thereon in the foregoing nickel-phosphorus plating conditions. In addition, a copper layer of 0.5 µm was additionally formed thereon in the foregoing copper plating conditions. And, ten circuits were printed thereon based on resist application and exposure processing, and etching treatment for removing the unwanted portions of the copper foil was performed.

An electroless tin plated layer was additionally formed on the (D) layer, and it was possible to form a favorable electroless tin plated layer with high adhesiveness.

### (Example 4)

In this Example, a copper clad laminate was prepared by bonding a rolled copper foil of 9 µm, in which a Ni-plated layer in a Ni plating amount of 700 µg/dm² was formed thereon in advance, to a resin substrate (polyimide-based resin). In addition, a copper plated layer to become the (D) layer was formed thereon in a thickness of 0.3 µm in the foregoing copper plating conditions.

Subsequently, ten circuits were printed thereon based on resist application and exposure processing, and etching treatment for removing the unwanted portions of the copper foil was performed.

An electroless nickel plated layer was additionally formed on the (D) layer, and it was possible to form a favorable electroless nickel plated layer with high adhesiveness.

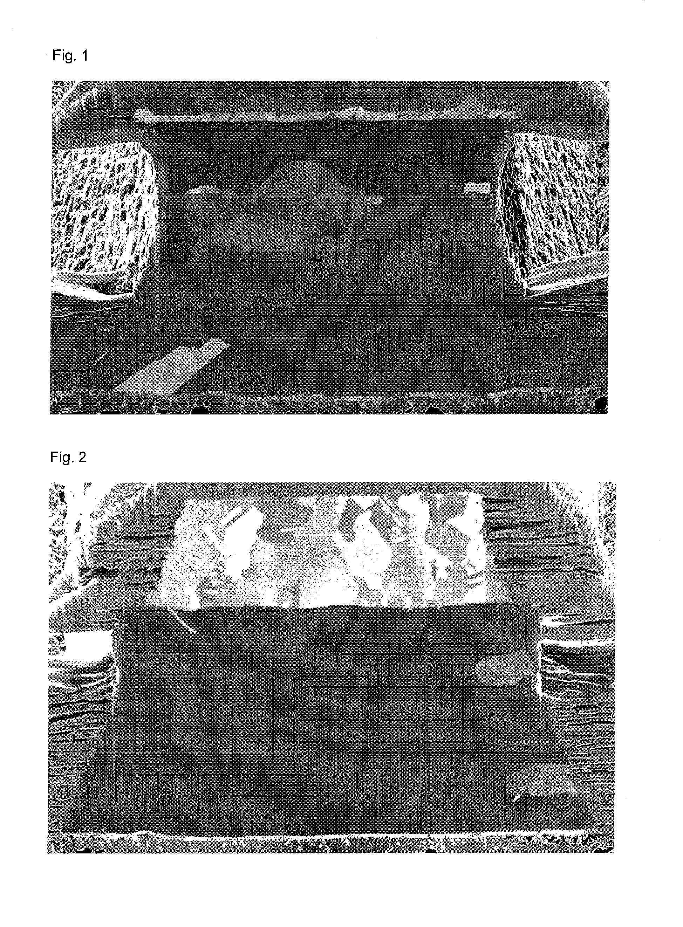

The cross section of the etching of the circuit is shown in Fig. 1. As shown in Fig. 1, it can be seen that a copper layer of 0.3 µm is formed on the uppermost part of the cross section of the circuit in the copper plating conditions. Moreover, it is possible to confirm that the cross section width of the circuit is etched in substantially uniform thickness from top to bottom.

Note that, with respect to this (D) layer, the etching was performed up to the thicknesses of 0.6 µm, 0.7 µm, 0.8 µm, and 0.9 µm, and, while the cross section tended to become trapezoidal as the layer thickness increased, the influence thereof could basically be ignored. Nevertheless, since it will be less wasteful as the (D) layer is thinner, if the formation of the "surface coated layer" to be formed thereon is possible, it could be said that the, desirably, the (D) layer is formed thin as possible.

### (Comparative Example 1)

An electrolytic copper foil had a foil thickness of 18 µm and was bonded to a resin substrate. And, a copper plated layer of 20 µm was formed on the copper clad laminate. The copper plating was performed in the foregoing conditions. Consequently, the total thickness of the electrolytic copper foil and the copper plated layer on the resin substrate was 38 µm. In addition, a copper plated layer to become the (D) layer was formed thereon in a thickness of 0.01 µm in the foregoing copper plating conditions. This condition deviates from the thickness of 0.05 µm or more of the present invention.

Subsequently, ten circuits were printed thereon based on resist application and exposure processing, and etching treatment for removing the unwanted portions of the copper foil was performed.

An electroless nickel plated layer was additionally formed on the (D) layer, and it was not possible to form a favorable electroless nickel plated layer with high adhesiveness.

### (Comparative Example 2)

A rolled copper foil had a foil thickness of 12 µm, and was bonded to a resin substrate. And, the copper clad laminate was etched to remove a part of the copper layer. Consequently, the copper thickness was 5 µm.

A Ni-plated layer in an amount of 25 µg/dm²; that is, the (C) layer was formed on the copper clad laminate in the foregoing Ni plating conditions.

Subsequently, ten circuits were printed thereon based on resist application and exposure processing, and etching treatment for removing the unwanted portions of the copper foil was performed.

While an attempt was made to additionally form an electroless tin plated layer on the (C) layer, it was not possible to form such electroless tin plated layer. The reason for this is considered to be that the (C) layer as the EF layer interfered with the electroless plating.

### (Comparative Example 3)

In Comparative Example 3, in the same conditions as Example 4, a copper clad laminate was prepared by bonding a rolled copper foil of 9 µm, in which a Ni-plated layer in a Ni plating amount of 700 µg/dm² was formed thereon in advance, to a resin substrate (polyimide-based resin).

In addition, a copper plated layer to become the (D) layer was formed thereon in a thickness of 4.5 µm in the foregoing copper plating conditions. This condition deviates from the thickness of less than 1 µm of the present invention.

Subsequently, ten circuits were printed thereon based on resist application and exposure processing, and etching treatment for removing the unwanted portions of the copper foil was performed.

An electroless nickel plated layer was additionally formed on the (D) layer, and it was possible to form a favorable electroless nickel plated layer with high adhesiveness. However, problems arose with respect to the etching properties.

The results upon observing the inclined angle of the circuit are shown in Fig. 2. As shown in Fig. 2, it can be seen that a thick copper layer is formed on the uppermost part of the cross section of the circuit. In addition, the inclined angle of the circuit descended and the cross section took on a trapezoidal shape. Moreover, the etching properties deteriorated. Moreover, it can be seen that the portion lower than the (C) layer is set back, and a step is formed.

This was determined to be a result of the (D) layer being too thick. Since the (D) layer is thick, it is considered that the balance with the function of the (C) layer for inhibiting etching was lost. Thus, it was confirmed that the formation of the (D) layer having excessive thickness; particularly, the formation of a copper layer of 1 µm or thicker should be avoided.

### INDUSTRIAL APPLICABILITY

The present invention yields an effect of being able to form a uniform circuit of the intended circuit width by adding a process of thinly forming a layer having a slower etching rate than that of copper to the series of processes for forming a circuit by etching a copper foil of a copper clad laminate, and additionally yields the effects of being able to reduce unetched portions, prevent the occurrence of sagging (reduction in length of tail of circuits), and shorten the time required for forming a circuit via etching.

In addition, the present invention yields a superior effect of being able to prevent the adhesiveness of the surface coated layer from being impaired by the copper or copper alloy layer formed on the EF layer, and enable the formation of a uniform circuit width, upon forming a plated layer at the upper part of the circuit.

Consequently, since the present invention can improve the etching properties in pattern etching and prevent the occurrence of short circuits and defects in the circuit width, and additionally enable plating to the circuit, the present invention is useful as a copper clad laminate (rigid and flexible laminates), and for forming an electronic circuit of a printed board.

## Claims

1. An electronic circuit as a laminated body configured from a layer (A) which is made of a copper or copper alloy foil formed on one surface or both surfaces of a resin substrate, a copper or copper alloy plated layer (B) formed on a part or whole surface of the (A) layer, a plated layer (C) formed on a part or whole surface of the (B) layer and having a slower etching rate than that of copper relative to a copper etching solution, and a copper or copper alloy plated layer (D) formed on the layer (C) and which has a thickness of 0.05 µm or more and less than 1 µm, and which is made of a copper circuit formed by etching and removing a part of the laminated portion of the (A) layer, the (B) layer, the (C) layer and the (D) layer up to the resin substrate surface.

2. An electronic circuit as a laminated body configured from a copper or copper alloy layer (A) which is formed on one surface or both surfaces of a resin substrate, a plated layer (C) formed on a part or whole surface of the (A) layer and has a slower etching rate than that of copper relative to a copper etching solution, and a copper or copper alloy plated layer (D) formed on the layer (C) and which has a thickness of 0.05 µm or more and less than 1 µm, and which is made of a copper circuit formed by etching and removing a part of the laminated portion of the (A) layer, the (C) layer and the (D) layer up to the resin substrate surface.

3. The electronic circuit according to claim 1 or claim 2, wherein the layer (C) having a slower etching rate than that of copper relative to a copper etching solution is made of nickel, cobalt or nickel alloy.

4. The electronic circuit according to any one of claims 1 to 3, wherein an amount of adhesion of the layer (C) is 100 µg/dm² to 3000 µg/dm².

5. The electronic circuit according to any one of claims 1 to 4, wherein a face which is opposite to a face of the copper or copper alloy layer (A) in contact with the resin is a face that is subject to one or more treatments among acid cleaning treatment, soft etching, and surface roughening treatment.

6. The electronic circuit according to any one of claims 1 to 5, wherein a face which is opposite to a face of the copper or copper alloy layer (A) in contact with the resin is a face that is subject to thickness reduction via one or more treatments among acid cleaning treatment, soft etching, and surface roughening treatment.

7. The electronic circuit according to any one of claims 1 to 6, wherein the copper or copper alloy layer (D) is a copper or copper alloy layer having a thickness of 0.05 µm or more and 0.8 µm or less.

8. The electronic circuit according to any one of claims 1 to 6, wherein the copper or copper alloy layer (D) is a copper or copper alloy layer having a thickness of 0.1 µm or more and 0.5 µm or less.

9. The electronic circuit according to any one of claims 1 to 8, wherein a heat-resistant layer and/or a chromate or organic anticorrosion layer is additionally provided on the copper or copper alloy layer (D).

10. The electronic circuit according to any one of claims 1 to 9, wherein a tin, nickel or gold plated layer, or a tin alloy, nickel alloy or gold alloy plated layer, or a solder plated layer is additionally provided on the copper or copper alloy layer (D) or on the heat-resistant layer and/or the chromate or organic anticorrosion layer.

11. A method of forming an electronic circuit, including a step of preparing a copper clad laminate by forming a copper or copper alloy layer (A) on one surface or both surfaces of a resin substrate, forming a copper or copper alloy plated layer (B) on a part or whole surface of the (A) layer, forming a plated layer (C), having a slower etching rate than that of copper relative to a copper etching solution, on a part or whole surface of the (B) layer, and forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (B) layer, the (C) layer and the (D) layer of the copper clad laminate up to the resin substrate surface.

12. A method of forming an electronic circuit, including a step of preparing a copper clad laminate by forming a copper or copper alloy layer (A) on one surface or both surfaces of a resin substrate, forming a through-hole on the copper clad laminate, additionally forming a copper or copper alloy plated layer (B) on a part or whole surface of the (A) layer and in the through-hole, subsequently forming a plated layer (C), having a slower etching rate than that of copper relative to a copper etching solution, on a part or whole surface of the (B) layer, and additionally forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (B) layer, the (C) layer and the (D) layer of the copper clad laminate up to the resin substrate surface.

13. A method of forming an electronic circuit, including a step of preparing a copper clad laminate by forming a copper or copper alloy layer (A) on one surface or both surfaces of a resin substrate, subsequently forming a plated layer (C), having a slower etching rate than that of copper relative to a copper etching solution, on a part or whole surface of the (A) layer, and additionally forming a copper or copper alloy plated layer (D), which has a thickness of 0.05 µm or more and less than 1 µm, on the layer (C), and a step of subsequently forming a copper circuit by etching and removing a part of the laminated portion of the (A) layer, the (C) layer and the (D) layer of the copper clad laminate up to the resin substrate surface.

14. The method of forming an electronic circuit according to any one of claims 11 to 13, wherein, as the copper foil to be used upon forming the copper or copper alloy layer (A) on one surface or both surfaces of the resin substrate, used is a copper foil in which a plated layer (C') having a slower etching rate than that of copper relative to a copper etching solution is provided to the copper foil surface in advance.

15. The method of forming an electronic circuit according to any one of claims 11 to 14, wherein a heat-resistant layer and/or an anticorrosion layer is formed on the (C) or (C') layer.

16. The method of forming an electronic circuit according to any one of claims 11 to 15, wherein the layer (C) or layer (C') having a slower etching rate than that of copper relative to a copper etching solution is made of nickel, cobalt or nickel alloy.

17. The method of forming an electronic circuit according to any one of claims 11 to 16, wherein an amount of adhesion of the layer (C) or layer (C') is adjusted to be 100 µg/dm² to 3000 µg/dm².

18. The method of forming an electronic circuit according to any one of claims 11 to 17, wherein the copper or copper alloy layer (A) is subject to one or more treatments among acid cleaning treatment, soft etching, and surface roughening treatment.

19. The method of forming an electronic circuit according to any one of claims 11 to 18, wherein the copper or copper alloy layer (A) is subject to thickness reduction via one or more treatments among acid cleaning treatment, soft etching, and surface roughening treatment.

20. The method of forming an electronic circuit according to any one of claims 11 to 19, further including a step of removing the heat-resistant layer and/or the anticorrosion layer via acid cleaning treatment or soft etching.

21. The method of forming an electronic circuit according to any one of claims 11 to 20, wherein the copper or copper alloy layer (D) is formed to have a thickness of 0.05 µm or more and 0.8 µm or less.

22. The method of forming an electronic circuit according to any one of claims 11 to 21, wherein the copper or copper alloy layer (D) is formed to have a thickness of 0.1 µm or more and 0.5 µm or less.

23. The method of forming an electronic circuit according to any one of claims 11 to 22, wherein a tin, nickel or gold plated layer, or a tin alloy, nickel alloy or gold alloy plated layer, or a solder plated layer is additionally formed on the copper or copper alloy layer (D) or on the heat-resistant layer and/or the chromate or organic anticorrosion layer.

24. A copper clad laminate for forming an electronic circuit configured from a copper or copper alloy layer (A) formed on one surface or both surfaces of a resin substrate, a copper or copper alloy plated layer (B) formed on a part or whole surface of the (A) layer, a plated layer (C) formed on a part or whole surface of the (B) layer and having a slower etching rate than that of copper relative to a copper etching solution, and a copper or copper alloy plated layer (D) formed on the layer (C) and which has a thickness of 0.05 µm or more and less than 1 µm.

25. A copper clad laminate for forming an electronic circuit configured from a copper or copper alloy layer (A) formed on one surface or both surfaces of a resin substrate, a plated layer (C) formed on a part or whole surface of the (A) layer and having a slower etching rate than that of copper relative to a copper etching solution, and a copper or copper alloy plated layer (D) formed on the layer (C) and which has a thickness of 0.05 µm or more and less than 1 µm.

26. The copper clad laminate for forming an electronic circuit according to claim 24 or claim 25, wherein the layer (C) having a slower etching rate than that of copper relative to a copper etching solution is made of nickel, cobalt or nickel alloy.

27. The copper clad laminate for forming an electronic circuit according to any one of claims 24 to 26, wherein an amount of adhesion of the layer (C) is 100 µg/dm² to 3000 µg/dm².

28. The copper clad laminate for forming an electronic circuit according to any one of claims 24 to 27, wherein a face which is opposite to a face of the copper or copper alloy layer (A) in contact with the resin is a face that is subject to one or more treatments
among acid cleaning treatment, soft etching, and surface roughening treatment.

29. The copper clad laminate for forming an electronic circuit according to any one of claims 24 to 28, wherein a face which is opposite to a face of the copper or copper alloy layer (A) in contact with the resin is a face that is subject to thickness reduction via one or more treatments among acid cleaning treatment, soft etching, and surface roughening treatment.

30. The copper clad laminate for forming an electronic circuit according to any one of claims 24 to 29, wherein the copper or copper alloy layer (D) is a copper or copper alloy layer having a thickness of 0.05 µm or more and 0.8 µm or less.

31. The copper clad laminate for forming an electronic circuit according to any one of claims 24 to 30, wherein the copper or copper alloy layer (D) is a copper or copper alloy layer having a thickness of 0.1 µm or more and 0.5 µm or less.

32. The copper clad laminate for forming an electronic circuit according to any one of claims 24 to 31, wherein a heat-resistant layer and/or a chromate or organic anticorrosion layer is additionally provided on the copper or copper alloy layer (D).

33. The copper clad laminate for forming an electronic circuit according to any one of claims 24 to 32, wherein a tin, nickel or gold plated layer, or a tin alloy, nickel alloy or gold alloy plated layer, or a solder plated layer is additionally provided on the copper or copper alloy layer (D) or on the heat-resistant layer and/or the chromate or organic anticorrosion layer.

34. The copper clad laminate for forming an electronic circuit according to any one of claims 24 to 33, wherein a copper clad laminate is prepared by forming a copper or copper alloy layer (A) on one surface or both surfaces of a resin substrate, forming a through-hole on the copper clad laminate, and additionally forming a copper or copper alloy plated layer (B) on a part or whole surface of the (A) layer and in the through-hole.

35. The copper clad laminate for forming an electronic circuit according to claim 34, wherein at least either the copper or copper alloy layer (A) formed on one surface or both surfaces of the resin substrate prior to the formation of a through-hole or a plated layer (through-hole plated layer) made of the subsequently formed copper or copper alloy layer (B) is subject to thickness reduction treatment via acid cleaning or/and soft etching.
